# EUROPÄISCHE PATENTSCHRIFT

(11) **EP 0 402 371 B1**
(45) Veröffentlichungstag und Bekanntmachung des Hinweises auf die Patenterteilung: **24.05.1995**
(21) Anmeldenummer: 89902518.3
(22) Anmeldetag: 22.02.1989
(51) Int. Cl.: H01L 39/12, H01L 39/24, C04B 35/00

(54) **HOCH-Tc-SUPRALEITER UND VERFAHREN ZU SEINER HERSTELLUNG**
HIGH-Tc SUPERCONDUCTOR AND PROCESS FOR PREPARING IT
SUPRACONDUCTEUR A HAUTE TEMPERATURE Tc ET SON PROCEDE DE PREPARATION

(30) Priorität: 25.02.1988 DE 3805954
(43) Veröffentlichungstag der Anmeldung: 19.12.1990
(73) Patentinhaber: HOECHST AKTIENGESELLSCHAFT, 65926 Frankfurt am Main (DE)
(72) Erfinder: MAIER, Joachim, D-7135 Wiernsheim (DE); RABENAU, Albrecht, D-7000 Stuttgart (DE); MURUGARAJ, Pandijan, D-7000 Stuttgart (DE)
(86) Internationale Anmeldenummer: EP8900163
(87) Internationale Veröffentlichungsnummer: WO8908330

(56) Entgegenhaltungen:
- EP-A- 0 277 749
- EP-A- 0 287 325
- Physical Review Letters, vol. 58, Nr. 9, March 1987 (New York, US) M.K. Wu et al.: "Superconductivity at 93K in a new mixid phase Y-Ba-Cu-O compound system at ambient pressure ", pages 908-910

## Beschreibung

Die vorliegende Erfindung betrifft einen Hoch-T_{c}-Supraleiter, insbesondere einen keramischen Supraleiter eines Typs, der mindestens je ein dreiwertiges und ein zweiwertiges Element, Kupfer und Sauerstoff enthält. Typische Vertreter solcher keramischer Hoch-T_{c}Supraleiter werden z. B. durch die allgemeinen Formeln ME_{2-y}R₂Oₓ, ME_{2-y}R₃Oₓ und M₂E_{3-y}R₂Oₓ repräsentiert, wobei
- M: mindestens ein dreiwertiges Element, wie ein Lanthanoidenelement, Wismut, Yttrium, ist,
- E: mindestens ein zweiwertiges Element, wie ein Erdalkalielement, ist und
- R: Kupfer ist und
- x: den Sauerstoffanteil angibt.

In der oben als zweites genannten Verbindung ist vorzugsweise 6,2 < x < 7,2.

Die Erfindung betrifft weiterhin ein Verfahren zum Herstellen von keramischen Hoch-T_{c}-Supraleitermaterialien. Es eignet sich besonders zur Herstellung von Hoch-T_{c}-Supraleitern des obigen Typs, läßt sich jedoch ganz allgemein anwenden, also z. B. auch auf das System La-Sr-Nb-O.

Unter dem Begriff "Hoch-T_{c}-Supraleiter" sollen hier Supraleiter-Materialien verstanden werden, deren Sprungtemperatur T_{c} über 30 K liegt.

Es ist bekannt, daß die keramischen Hoch-T_{c}-Supraleiter der oben erwähnten Typen eine stark anisotrope Kristallstruktur haben und daß ihre Supraleitereigenschaften, wie die kritische Stromdichte und die kritische Feldstärke, bezogen auf die Kristallstruktur stark richtungsabhängig sind. Man ist daher bestrebt, möglichst große Einkristalle aus den genannten Materialien herzustellen. Größere Volumina dieser keramischen Supraleitermaterialien lassen sich nach dem derzeitigen Stand der Technik jedoch nur in polykristalliner Form wirtschaftlich herstellen und die einzelnen Kristallite oder Körner des polykristallinen Materials müssen dann kristallographisch gleichartig ausgerichtet werden, wenn die optimalen Supraleitereigenschaften ausgenutzt werden sollen.

Aus einer Veröffentlichung von Wu und Ruckenstein in MATERIALS LETTERS, Band 5, No. 11.12, Oktober 1987, S. 432-435 ist es bekannt, daß die kritische Stromdichte und die kritische Feldstärke von YBa₂Cu₃O₇ in Richtung der |001|-Ebenen, d.h. der Cu-O-Ebenen, besonders hoch ist und daß sich diese Ebenen in polykristallinem Material durch Pressen und anschließendes Sintern senkrecht zur Preßrichtung ausrichten lassen.

Aus einer Veröffentlichung von Omori et al., JAPANESE JOURNAL OF APPLIED PHYSICS, Band 26, No. 8, August 1987, S. L1421- L1421-L1423 ist es bekannt, orientierte orthorhombische YBa₂Cu₃O₇₋ₓ-Polykristalle aus tetragonalen, plättchenartigen Kristallen durch Mahlen, Pressen und Sintern in einer Sauerstoffatmosphäre herzustellen.

Aus einer Veröffentlichung in Science Bd. 238 (1987) S. 1655 - 1656 ist es bekannt, daß orientierte Körner eines Yttrium-Barium-Kupferoxid-Supraleiters durch Schmelzen bei 1300°C, kontrolliertes Abkühlen und anschließendes Tempern zum Aufoxidieren hergestellt werden können. Die kritische Stromdichte konnte dadurch um mehrere Zehnerpotenzen erhöht werden.

Aus Accounts of Chemical Research, 21, No. 1, S. 1 bis 7 ist es bekannt, die Ba-Plätze eines YBCO-Supraleiters mit Alkalimetallionen (K, Rb, Cs) zu dotieren, wobei YBa₂Cu₃O_{7-y} erhalten wurde. Beim Ersatz des Cu durch Ni oder Co verringerte sich die Sprungtemperatur T_{c} beträchtlich.

Hoch-T_{c}-Supraleiter mit der Formel LaBa₂Cu₃O₇₋ₓ und RBa₂Cu₃O₇₋ₓ (orthorhombisch; R = Y, Sm, Eu, Gd, Dy, Ho, Tm, Yb, Lu; 0 < x < 0,2) sind aus Nature, Bd. 329, 17. 9. 1987, S. 227-229 bekannt.

Die bekannten Verfahren zum Herstellen strukturierter oder orientierter polykristalliner keramischer Hoch-T_{c}-Supraleitermaterialien sind kompliziert, zeitraubend und nicht immer gut reproduzierbar. Einkristalle aus Hoch-T_{c}-Supraleitern konnten bisher nur mit relativ kleinen Abmessungen hergestellt werden. Der vorliegenden Erfindung liegt dementsprechend die Aufgabe zugrunde, ein polykristallines Hoch-T_{c}-Supraleitermaterial mit kristallographisch weitestgehend ausgerichteten Körnern und/oder mit relativ großen Einkristallen sowie ein einfaches und reproduzierbares Verfahren zum Herstellen eines solchen Supraleitermaterials anzugeben.

Gelöst wird diese Aufgabe durch einen Formkörper der eingangs genannten Gattung, dessen Kennzeichenmerkmale in Patentanspruch 1 und dessen nähere Ausgestaltungen in den Patentansprüchen 2 bis 4 angegeben sind, sowie durch ein Verfahren nach Anspruch 5, dessen bevorzugte Ausführungsformen in den Ansprüchen 6 bis 9 angegeben sind.

Das erfindungsgemäße Verfahren wird bevorzugterweise so geführt, daß eine Ausgangsmischung verwendet wird, die das Erdalkalielement E in 5 bis 10 % unter der stöchiometrischen Menge enthält. Der molare Anteil des Fremdelements, also z.B. des Alkalimetalls, das in Form des Oxids eingebracht wird, kann erfindungsgemäß bis zum Zehnfachen des molaren Defizits betragen.

Das zugesetzte Material verflüchtigt sich beim Reaktionsglühen oder Sintern, das bei üblichen Temperaturen in Luft oder Sauerstoff durchgeführt wird, weitestgehend und es verbleiben nur Spuren des Fremdelements in der Größenordnung von ppm bis einigen Promille bezogen auf den molaren Anteil an zweiwertigem Element im fertigen Supraleitermaterial zurück. Mit einer alleinigen Reduzierung des Anteils an zwei- und/oder dreiwertigem Element in der Ausgangsmaterialmischung konnte der Orientierungseffekt nicht erzielt werden. Die Substitution eines Teiles des Anteils an zweiwertigem Element (insbesondere Erdalkalielement) durch mindestens ein Fremdelement (insbesondere Alkalielement) in der Ausgangsmaterialmischung liefert die besten Ergebnisse. Vorteilhaft scheint auch zu sein, wenn der Ionenradius des Elements der entfernbaren Verbindung etwa gleich dem Ionenradius des substituierten zweiwertigen Elements ist.

Die Erfindung ist vor allem für Supraleiter mit "YBaCu"- oder "123"-Struktur, wie Yttriumbariumcuprat, geeignet, wobei, wenn das Erdalkalimetall Barium ist, als entfernbare oder verflüchtigbare Verbindung vorzugsweise eine Kaliumverbindung, wie Kaliumoxid oder Kaliumcarbonat, verwendet wird. Die Erfindung läßt sich jedoch auch bei keramischen Supraleitermaterialien mit anderer Struktur anwenden, z. B. vom Typ Lanthanstrontiumcuprat, Wismutcalciumstrontiumcuprat, Lanthanstrontiumniobat und analogen Verbindungen. Wenn das Supraleitermaterial Erdalkalielemente mit kleinerem Ionenradius als Ba enthält, werden als verflüchtigbare Verbindungen vorzugsweise Verbindungen von Alkalimetallen mit kleinerem Ionenradius als Kalium verwendet.

Das in der oben beschriebenen Weise durch Reaktionsglühen erhaltene Material ist im allgemeinen noch etwas porös. Um ein dichtes Material mit kristallographisch ausgerichteten Körnern herzustellen, wird das beim Reaktionsglühen erhaltene Material zerkleinert, z. B. in einem Mörser oder einer Kugelmühle, dann in Form gepreßt und anschließend gesintert. Man erhält durch diesen zusätzlichen Preß- und Sintervorgang ein praktisch völlig dichtes Material, das zu 95% oder mehr orientiert ist.

Durch die Erfindung werden einige wesentliche Vorteile gegenüber dem Stand der Technik erzielt:

Vor allem lassen sich Formkörper mit kristallographisch senkrecht zur c-Achse weitestgehend ausgerichteten Körnern herstellen. Im Rahmen der Genauigkeit von Röntgenspektren kann eine 100%ige Ausrichtung erreicht werden. Das Verfahren eignet sich auch zur Bildung von dünnen epitaktischen Schichten aus Hoch-T_{c}-Supraleitermaterialien auf geeigneten Substraten.

Das Verfahren ermöglicht auch die Herstellung relativ großer Einkristalle, es ist einfach und benötigt relativ wenig Zeit, eine Nachbehandlung, wie ein Glühen in Sauerstoff, ist nicht erforderlich.

Ein weiterer wesentlicher Vorteil der vorliegenden Supraleitermaterialien besteht darin, daß sie wesentlich beständiger gegen äußere Einflüsse, wie die Atmosphäre, Feuchtigkeit und Mineralsäuren, sind als die bekannten keramischen Supraleitermaterialien.

## Patentansprüche

1. Keramischer Formkörper aus einem Hoch-T_{c}-Supraleiter eines Typs, wie er durch die allgemeinen Formeln ME_{2-y}R₂Oₓ, ME_{2-y}R₃Oₓ, M₂E_{3-y}R₂Oₓ repräsentiert wird, wobei M mindestens ein Lanthanoidenelement, Yttrium und/oder Wismut, E mindestens ein Erdalkalielement, R Kupfer und x den Sauerstoffanteil bedeuten, dadurch gekennzeichnet, daß 0,05 < y < 0,3 für ME_{2-y}R₃Oₓ und 0,1 < y < 0,3 für ME_{2-y}R₂Oₓ und M₂E_{3-y}R₂Oₓ gilt und die Kristallkörper des keramischen Formkörpers weitgehend senkrecht zur c-Achse ausgerichtet sind.

2. Formkörper nach Anspruch 1, dadurch gekennzeichnet, daß er Spuren eines Alkalielements enthält.

3. Formkörper nach Anspruch 1, dadurch gekennzeichnet, daß er, bezogen auf den Gehalt an zweiwertigem Element, einen Fremdanteil im ppm-bis Promille-Bereich enthält.

4. Formkörper nach Anspruch 1, dadurch gekennzeichnet, daß seine Zusammensetzung im wesentlichen der Formel
YBa_{1,95}Cu₃O_{6,45+0,25}
entspricht.

5. Verfahren zum Herstellung eines keramischen Hoch-T_{c}-Supraleiters nach einem der Ansprüche 1 bis 4, bei welchem eine Ausgangsmischung hergestellt wird, die oxidische Verbindungen mindestens eines dreiwertigen Elements der Gruppe der Lanthanoiden und/oder Yttrium und/oder Wismut, mindestens eines Erdalkalielements und des Kupfers enthält, und die Mischung geglüht wird, dadurch gekennzeichnet, daß eine Ausgangsmischung verwendet wird, die das Erdalkalielement E in bis zu 15 % unter der stöchiometrischen Menge enthält und der eine beim Glühen entweichende anorganische Fremdelement-Verbindung zugesetzt ist, wobei der molare Anteil des Fremdelements mindestens gleich dem molaren Defizit des Erdalkalielements E ist, und daß die Fremdelement-Verbindung durch Glühen bei der Herstellungstemperatur entfernt wird.

6. Verfahren nach Anspruch 5, dadurch gekennzeichnet, daß das Fremdelement der anorganischen Fremdelement-Verbindung mindestens ein Alkalimetall und/oder Blei ist.

7. Verfahren nach Anspruch 5, dadurch gekennzeichnet, daß als Erdalkalielement Barium und als Fremdelement-Verbindung eine Verbindung von Kalium verwendet werden.

8. Verfahren nach Anspruch 5, dadurch gekennzeichnet, daß die geglühte Mischung abgekühlt, zerkleinert, in eine Form gepreßt und dann erneut geglüht wird.

9. Verfahren nach Anspruch 5, dadurch gekennzeichnet, daß die Mischung in Luft geglüht wird.

## Claims

1. A ceramic molded body made of a high-T_{c} superconductor of a type such as is represented by the formulae ME_{2-y}R₂Oₓ, ME_{2-y}R₃Oₓ and M₂E_{3-y}R₂Oₓ, where M denotes at least one lanthanide element, yttrium and/or bismuth, E denotes at least one alkaline earth element, R denotes copper and x denotes the proportion of oxygen, wherein 0.05 < y < 0.3 applies for ME_{2-y}R₃Oₓ and 0.1 < y < 0.3 for ME_{2-y}R₂Oₓ and M₂E_{3-y}R₂Oₓ and the crystal grains of the ceramic molded body are aligned substantially perpendicular to the c-axis.

2. A molded body as claimed in claim 1, which contains traces of an alkali-metal element.

3. A molded body as claimed in claim 1, which contains a foreign component in the ppm to parts per thousand range, based on the content of divalent element.

4. A molded body as claimed in claim 1, whose composition essentially corresponds to the formula
YBa_{1.95}Cu₃O_{6.45 + 0.25}.

5. A process for preparing a ceramic high-T_{c} superconductor as claimed in one of claims 1 to 4, in which process a starting mixture is prepared which contains oxidic compounds of at least one trivalent element of the lanthanide group and/or yttrium and/or bismuth, of at least one alkaline earth element, and of copper, and the mixture is annealed, which process comprises using a starting mixture which contains the alkaline earth element E in an amount up to 15% below the stoichiometric amount and to which starting mixture there is added an inorganic foreign element compound which escapes during annealing, the molar proportion of the foreign element being at least equal to the molar deficit of the alkaline earth element E, and removing the foreign element compound by annealing at the preparation temperature.

6. The process as claimed in claim 5, wherein the foreign element of the inorganic foreign element compound is at least one alkali metal and/or lead.

7. The process as claimed in claim 5, wherein barium is used as alkaline earth element and a compound of potassium is used as foreign element compound.

8. The process as claimed in claim 5, wherein the annealed mixture is cooled, comminuted, pressed into a mold and then annealed again.

9. The process as claimed in claim 5, wherein the mixture is annealed in air.

## Revendications

1. Corps moulé céramique constitué par un supraconducteur à température (T_{c}) élevéed'un type représenté par les formules générales ME_{2-y}R₃ₓ, ME_{2-y}R₃Oₓ, Me₂E_{3-y}R₂Oₓ, M désignant au moins un élément des lanthanides, de l'yttrium et/ou du bismuth, E au moins un élément alcalino-terreux, R le cuivre et x le pourcentage d'oxygène, caractérisé en ce que l'on a 0,05 < y < 0,3 pour ME₂_{-y}R₃Oₓ et 0,1 < y < 0,3 pour ME_{2-y}R₂Oₓ et ME_{3-y}R₂Oₓ, et que les corps cristallins du corps moulé céramique sont orientés dans une large mesure perpendiculairement à l'axe c.

2. Corps moulé selon la revendication 1, caractérisé en ce qu'il contient des traces d'un élément alcalin.

3. Corps moulé selon la revendication 1, caractérisé en ce qu'il contient un pourcentage de substance étrangère, rapporté à la teneur en un élément bivalent, dans une gamme allant de quelques ppm à quelques pour mille.

4. Corps moulé selon la revendication 1, caractérisé en ce que sa composition correspond essentiellement à la formule
YBa_{1,95}CU₃O_{6,45+0,25}.

5. Procédé pour fabriquer un supraconducteur céramique à température T_{c} élevée selon l'une des revendications 1 à 4, selon lequel on prépare un mélange initial, qui contient des composés oxydés d'au moins un élément trivalent du groupe des lanthanides et/ou l'yttrium, et/ou le bismuth, au moins un élément alcalino-terreux et le cuivre, et on soumet le mélange à une calcination, caractérisé en ce qu'on utilise le mélange initial, qui contient l'élément alcalino-terreux E en un pourcentage atteignant jusqu'à 15 % au-dessous de la quantité stoechiométrique et auquel est ajouté un composé d'un élément étranger minéral, qui se dégage lors de la calcination, le pourcentage molaire de l'élément étranger étant au moins égal au déficit molaire de l'élément alcalino-terreux E et qu'on élimine le composé de l'élément étranger par calcination à la température de fabrication.

6. Procédé selon la revendication 5, caractérisé en ce que l'élément étranger du composé minéral de l'élément étranger est au moins un métal alcalin et/ou du plomb.

7. Procédé selon la revendication 5, caractérisé en ce qu'on utilise du baryum comme élément alcalino-terreux et un composé du potassium en tant que composé de l'élément étranger.

8. Procédé selon la revendication 5, caractérisé en ce qu'on refroidit le mélange recuit, on le fragmente, on le comprime dans un moule et ensuite on lui fait subir à nouveau une calcination.

9. Procédé selon la revendication 5, caractérisé en ce qu'on calcine le mélange dans l'air.
